# EUROPÄISCHE PATENTANMELDUNG

(11) **EP 4 312 243 A1**
(43) Veröffentlichungstag der Anmeldung: **31.01.2024**
(21) Anmeldenummer: 23183568.7
(22) Anmeldetag: 05.07.2023
(51) Int. Cl.: H01H 71/08, H02M 7/00

(54) **EINSCHUB-SUMMENSTROMWANDLER-BAUGRUPPE, REIHENEINBAUGERÄT UND MONTAGEVERFAHREN**

(30) Priorität: 28.07.2022 DE 102022207779
(71) Anmelder: Siemens Aktiengesellschaft, 80333 München (DE)
(72) Erfinder: Keimel, Tobias, 93049 Regensburg (DE); Koch, Michael, 92272 Freudenberg (DE); Schaich, Sebastian, 93051 Regensburg (DE)
(74) Vertreter: Siemens Patent Attorneys

(57) **Zusammenfassung**

Die erfindungsgemäße Einschub-Summenstromwandler-Baugruppe (100) zum Einschieben in einen modulübergreifenden Einbauraum (9) eines aus mehreren Gehäusemodulen (11, 12, 13, 14) gebildeten, mehrpoligen Reiheneinbaugerätes (1) weist einen Summenstromwandler (101) sowie zumindest einem ersten und einem zweiten Primärleiter (110, 120, 130, 140) auf, welche jeweils zumindest einmal durch den rohrförmigen Summenstromwandler (101) hindurchgeführt sind und ihrerseits jeweils ein erstes und ein zweites Primärleiterende (111, 112, 121, 122, 131, 132, 141, 142) aufweisen. Weiterhin weist die Einschub-Summenstromwandler-Baugruppe (100) einen am Summenstromwandler (101) befestigten, zwischen einer Fixierposition und einer Freigabeposition bewegbaren Primärleiterhalter (102) zum Fixieren der ersten und zweiten Primärleiterenden (111, 112, 121, 122, 131, 132, 141, 142) auf, welcher dazu ausgebildet ist, in der Fixierposition die ersten und zweiten Primärleiterenden (111, 112, 121, 122, 131, 132, 141, 142) während des Einschiebens in den modulübergreifenden Einbauraum (9) in einer jeweiligen Montageposition zu halten und nach dem Einschieben durch Bewegen in die Freigabeposition die ersten und zweiten Primärleiterenden (111, 112, 121, 122, 131, 132, 141, 142) in eine jeweilige Fügeposition zu verbringen. Durch den modularen Aufbau und das Einschieben der großvolumigen Einschub-Summenstromwandler-Baugruppe (100) in den modulübergreifenden Einbauraum (9) wird der Montageaufwand deutlich vereinfacht.

## Beschreibung

Die Erfindung betrifft eine Einschub-Summenstromwandler-Baugruppe zum Einschieben in einen modulübergreifenden Einbauraum eines aus mehreren Gehäusemodulen gebildeten Isolierstoffgehäuses eines mehrpoligen Reiheneinbaugerätes, mit einem rohrförmigen Summenstromwandler sowie zumindest einem ersten und einem zweiten Primärleiter, welche jeweils zumindest einmal durch den rohrförmigen Summenstromwandler hindurchgeführt sind und jeweils ein erstes und ein zweites Primärleiterende aufweisen. Weiterhin betrifft die Erfindung ein modular gebildetes, mehrpoliges Reiheneinbaugerät mit einer derartigen Einschub-Summenstromwandler-Baugruppe sowie ein Verfahren zur Montage einer derartigen Einschub-Summenstromwandler-Baugruppe in einem modulübergreifenden Einbauraum eines modular gebildeten, mehrpoligen Isolierstoffgehäuses eines derartigen, modular gebildeten mehrpoligen Reiheneinbaugerätes.

Elektromechanische Schutzschaltgeräte - beispielsweise Leistungsschalter, Leitungsschutzschalter, Fehlerstromschutzschalter sowie Lichtbogen- bzw. Brandschutzschalter - dienen der Überwachung sowie der Absicherung eines elektrischen Stromkreises und werden insbesondere als Schalt- und Sicherheitselemente in elektrischen Energieversorgungs- und Verteilnetzen eingesetzt. Zur Überwachung und Absicherung des elektrischen Stromkreises wird das Schutzschaltgerät über zwei oder mehrere Anschlussklemmen mit einer elektrischen Leitung des zu überwachenden Stromkreises elektrisch leitend verbunden, um bei Bedarf den elektrischen Strom in der jeweiligen überwachten Leitung zu unterbrechen. Das Schutzschaltgerät weist hierzu zumindest einen Schaltkontakt auf, der bei Auftreten eines vordefinierten Zustandes - beispielsweise bei Erfassen eines Kurzschlusses oder eines Fehlerstromes - geöffnet werden kann, um den überwachten Stromkreis vom elektrischen Leitungsnetz zu trennen. Derartige Schutzschaltgeräte sind auf dem Gebiet der Niederspannungstechnik auch als Reiheneinbaugeräte bekannt.

Leistungsschalter sind dabei speziell für hohe Ströme ausgelegt. Ein Leitungsschutzschalter (sogenannter LS-Schalter), welcher auch als "Miniature Circuit Breaker" (MCB) bezeichnet wird, stellt in der Elektroinstallation eine sogenannte Überstromschutzeinrichtung dar und wird insbesondere im Bereich der Niederspannungsnetze eingesetzt. Leistungsschalter und Leitungsschutzschalter garantieren ein sicheres Abschalten bei Kurzschluss und schützen Verbraucher und Anlagen vor Überlast, beispielsweise vor Beschädigung der elektrischen Leitungen durch zu starke Erwärmung in Folge eines zu hohen elektrischen Stromes. Sie sind dazu ausgebildet, einen zu überwachenden Stromkreis im Falle eines Kurzschlusses oder bei Auftreten einer Überlast selbsttätig abzuschalten und damit vom übrigen Leitungsnetz zu trennen. Leistungsschalter und Leitungsschutzschalter werden daher insbesondere als Schalt- und Sicherheitselemente zur Überwachung und Absicherung eines elektrischen Stromkreises in elektrischen Energieversorgungsnetzen eingesetzt. Leitungsschutzschalter sind aus den Druckschriften DE 10 2015 217 704 A1, EP 2 980 822 A1, DE 10 2015 213 375 A1, DE 10 2013 211 539 A1 oder auch EP 2 685 482 B1 prinzipiell vorbekannt.

Zur Unterbrechung einer einzigen Phasenleitung wird in der Regel ein einpoliger Leitungsschutzschalter verwendet, welche üblicher Weise eine Breite von einer Teilungseinheit (entspricht ca. 18mm) aufweist. Für dreiphasige Anschlüsse werden (alternativ zu drei einpoligen Schaltgeräten) dreipolige Leitungsschutzschalter eingesetzt, welche dementsprechend eine Breite von drei Teilungseinheiten (entspricht ca. 54mm) aufweisen. Jedem der drei Phasenleiter ist dabei ein Pol, d.h. eine Schaltstelle zugeordnet. Soll zusätzlich zu den drei Phasenleitern auch noch der Neutralleiter unterbrochen werden, spricht man von vierpoligen Geräten, welche vier Schaltstellen aufweisen: drei für die drei Phasenleiter sowie einen für den gemeinsamen Neutralleiter.

Daneben existieren kompakte Leitungsschutzschalter, welche bei einer Gehäusebreite von nur einer Teilungseinheit zwei Schaltkontakte für je eine Anschlussleitung, d.h. entweder für zwei Phasenleitungen (Kompaktleitungsschutzschalter vom Typ 1+1) oder für eine Phasenleitung und den Neutralleiter (Kompaktleitungsschutzschalter vom Typ 1+N), bereitstellen. Derartige Kompakt-Schutzschaltgeräte in Schmalbauweise sind beispielsweise aus den Druckschriften DE 10 2004 034 859 A1, EP 1 191 562 B1 oder EP 1 473 750 A1 prinzipiell vorbekannt.

Ein Fehlerstromschutzschalter ist eine Schutzeinrichtung zur Gewährleistung eines Schutzes gegen einen gefährlichen Fehlerstrom in einer elektrischen Anlage. Ein derartiger Fehlerstrom - welcher auch als Differenzstrom bezeichnet wird - tritt auf, wenn ein spannungsführendes Leitungsteil einen elektrischen Kontakt gegen Erde aufweist. Dies ist beispielsweise dann der Fall, wenn eine Person ein spannungsführendes Teil einer elektrischen Anlage berührt: in diesem Fall fließt der Strom als Fehlerstrom durch den Körper der betreffenden Person gegen die Erdung ab. Zum Schutz gegen derartige Körperströme muss der Fehlerstromschutzschalter bei Auftreten eines derartigen Fehlerstroms die elektrische Anlage schnell und sicher allpolig vom Leitungsnetz trennen. Im Allgemeinen Sprachgebrauch werden anstelle des Begriffs "Fehlerstromschutzschalter" auch die Begriffe FI-Schutzschalter (kurz: FI-Schalter), Differenzstromschutzschalter (kurz: DI-Schalter) oder RCD (für "Residual Current Protective Device") gleichwertig verwendet.

Bei Fehlerstromschutzschaltern wird ferner zwischen netzspannungsabhängigen und netzspannungsunabhängigen Gerätetypen unterschieden: während netzspannungsabhängige Fehlerstromschutzschalter eine Steuerungselektronik mit einem Auslöser aufweisen, die zur Erfüllung ihrer Funktion auf eine Hilfs- oder Netzspannung angewiesen ist, benötigen netzspannungsunabhängige Fehlerstromschutzschalter zur Realisierung der Auslösefunktion keine Hilfs- oder Netzspannung, sondern weisen zur Realisierung der netzspannungsunabhängigen Auslösung in der Regel einen etwas größeren Summenstromwandler auf, wodurch ein größerer Induktionsstrom in der Sekundärwicklung erzeugt werden kann.

Daneben existieren auch Gerätebauformen, bei denen die Funktionalität eines Fehlerstrom-Schutzschalters mit der Funktionalität eines Leitungsschutzschalters kombiniert wird: derartige kombinierte Schutzschaltgeräte werden im Deutschen als FI/LS oder im englischsprachigen Raum als RCBO (für Residual current operated Circuit-Breaker with Overcurrent protection) bezeichnet. Diese Kombigeräte haben im Vergleich zu getrennten Fehlerstrom- und Leitungsschutzschaltern den Vorteil, dass jeder Stromkreis seinen eigenen Fehlerstrom-Schutzschalter aufweist: Normalerweise wird ein einziger FehlerstromSchutzschalter für mehrere Stromkreise verwendet. Kommt es zu einem Fehlerstrom, werden somit in Folge alle abgesicherten Stromkreise abgeschaltet. Durch den Einsatz von RCBOs wird nur der jeweils betroffene Stromkreis abgeschaltet.

Zur Erfassung eines derartigen Fehler- bzw. Differenzstromes wird die Größe des Stromes in einer zu einem elektrischen Verbraucher hinführenden Leitung, beispielsweise einer Phasenleitung, mit der Größe des Stromes in einer vom elektrischen Verbraucher zurückführenden Leitung, beispielsweise eines Neutralleiters, mit Hilfe eines sogenannten Summenstromwandlers verglichen. Dieser weist einen ringförmigen Magnetkern auf, durch den die Primärleiter (hin- und rückführende elektrische Leitungen) hindurchgeführt sind. Der Magnetkern selbst ist mit einem Sekundärleiter bzw. einer Sekundärwicklung umwickelt. Im fehlerstromfreien Zustand ist die Summe der zu dem Verbraucher hinfließenden elektrischen Ströme gleich der Summe der vom Verbraucher zurückfließenden elektrischen Ströme. Werden die Ströme vektoriell, d.h. richtungsbezogen bzw. vorzeichenbehaftet, addiert, so folgt hieraus, dass die vorzeichenbehaftete Summe der elektrischen Ströme in den Hin- und Rückleitungen im fehlerstromfreien Zustand gleich Null ist: im Sekundärleiter wird kein Induktionsstrom induziert. Im Unterschied dazu ist im Falle eines Fehler- bzw. Differenzstromes, der gegen Erde abfließt, die im Summenstromwandler erfasste Summe der hin- beziehungsweise zurückfließenden elektrischen Ströme ungleich Null. Die dabei auftretende Stromdifferenz führt dazu, dass an der Sekundärwicklung eine der Stromdifferenz proportionale Spannung induziert wird, wodurch ein Sekundärstrom in der Sekundärwicklung fließt. Dieser Sekundärstrom dient als Fehlerstromsignal und führt nach Überschreiten eines vorbestimmten Wertes zum Auslösen des Schutzschaltgerätes und infolgedessen - durch Öffnen des zumindest einen Schaltkontaktes des Schutzschaltgerätes - zur Abschaltung des entsprechend abgesicherten Stromkreises.

Insbesondere bei mehrpoligen Fehlerstromschutzschaltern - ob als reiner Fehlerstromschutzschalter oder als kombinierte Gerätebauform wie FI/LS bzw. RCBO - müssen bei der Montage des Summenstromwandlers die die vergleichsweise dicken Primärleiter manuell durch den ringförmigen Magnetkern hindurch gefädelt werden. Gerade bei kompakten Schutz- oder Messeinrichtungen, welche nur über einen geringen Bauraum verfügen, ist eine derartige Montage vergleichsweise aufwändig und zwingend von Hand auszuführen.

Es ist deshalb die Aufgabe der vorliegenden Erfindung, eine Einschub-Summenstromwandler-Baugruppe zum Einschieben in einen modulübergreifenden Einbauraum eines aus mehreren Gehäusemodulen gebildeten, mehrpoligen Reiheneinbaugerätes, ein modular gebildetes, mehrpoliges Reiheneinbaugerät mit einer derartigen Einschub-Summenstromwandler-Baugruppe sowie ein Verfahren zur Montage einer derartigen Einschub-Summenstromwandler-Baugruppe in einem derartigen Reiheneinbaugerät bereitzustellen, welche sich durch eine vereinfachte Montage auszeichnen.

Diese Aufgabe wird erfindungsgemäß durch die Einschub-Summenstromwandler-Baugruppe, das modular gebildete, mehrpolige Reiheneinbaugerät sowie das Montageverfahren gemäß den unabhängigen Ansprüchen gelöst. Vorteilhafte Ausgestaltungen sind Gegenstand der abhängigen Ansprüche.

Die erfindungsgemäße Einschub-Summenstromwandler-Baugruppe zum Einschieben in einen modulübergreifenden Einbauraum eines aus mehreren Gehäusemodulen gebildeten, mehrpoligen Reiheneinbaugerätes weist einen Summenstromwandler sowie zumindest einem ersten und einem zweiten Primärleiter auf, welche jeweils zumindest einmal durch den rohrförmigen Summenstromwandler hindurchgeführt sind und ihrerseits jeweils ein erstes und ein zweites Primärleiterende aufweisen. Weiterhin weist die Einschub-Summenstromwandler-Baugruppe einen am Summenstromwandler befestigten, zwischen einer Fixierposition und einer Freigabeposition bewegbaren Primärleiterhalter zum Fixieren der ersten und zweiten Primärleiterenden auf, welcher dazu ausgebildet ist, in der Fixierposition die ersten und zweiten Primärleiterenden während des Einschiebens in den modulübergreifenden Einbauraum in einer jeweiligen Montageposition zu halten und nach dem Einschieben durch Bewegen in die Freigabeposition die ersten und zweiten Primärleiterenden in eine jeweilige Fügeposition zu verbringen.

Der Summenstromwandler weist eine ring-, rohr- oder torusförmige Gestalt auf, durch deren Öffnung der erste und zweite Primärleiter bereits vor der Montage in einem Gehäuse des Reiheneinbaugerätes hindurchgeführt sind. Im Gegensatz zu einer Montage in sogenannter "Topf-Deckel-Bauweise", bei der in einen die Befestigungsseite sowie Teile der Schmal- und Breitseiten umfassenden Gehäusetopf die Baugruppen und Komponenten - insbesondere auch der Summenstromwandler - des Reiheneinbaugerätes eingesetzt und montiert werden, bevor das Gehäuse durch Aufsetzen eines die Frontseite sowie Teile der Schmal- und Breitseiten umfassenden Gehäusedeckels verschlossen wird, stellt das Einschieben der Einschub-Summenstromwandler-Baugruppe über die Breitseite des ansonsten fertig bestückten Isolierstoffgehäuses eine deutliche Erleichterung dar, insbesondere deshalb, weil der Summenstromwandler bereits außerhalb des Gehäuses mit den Primärleitern bewickelt, d.h. vormontiert werden kann, so dass die Primärleiter nicht nach dem Einsetzen in den Gehäusetopf von Hand durch den Summenstromwandler hindurchgefädelt werden müssen. Der Montageaufwand wird dadurch deutlich vereinfacht. Da die Fügerichtung bei einem Gehäuse in "Topf-Deckel-Bauweise" im Gegensatz zur sogenannten "Schalenbauweise" um 90° gedreht ist, ist dort ein modularer Aufbau nicht realisierbar.

Das Isolierstoffgehäuse des mehrpoligen Reiheneinbaugerätes ist modular aufgebaut, d.h. aus mehreren Gehäusemodulen gebildet. Hierunter ist zu verstehen, dass die einzelnen Pole, beispielsweise eines MCBs, d.h. eines Leitungsschutzschalters oder eines RCDs, d.h. eines Fehlerstromschutzschalters, vor der Montage der Einschub-Summenstromwandler-Baugruppe bereits vollständig in jeweils einem eigenen Gehäusemodul vormontiert sind. Die das Reiheneinbaugerät bildenden Gehäusemodule, beispielsweise ein RCD- und ein MCB-Modul für einen zweipoliges, oder ein RCD- und drei MCB-Module für ein vierpoliges Schutzschaltgerät (jeweils vom Typ FI/LS) werden anschließend noch mechanisch zu einem - bis auf die Einschub-Summenstromwandler-Baugruppe vollständig vorbestückten Isolierstoffgehäuse verbunden. Die einzelnen Gehäusemodule weisen jeweils eine von einer zur anderen Breitseite durchgängige Einbauöffnung auf, welche nach dem Verbinden einen modulübergreifenden Einbauraum bilden.

Bei der Montage der Einschub-Summenstromwandler-Baugruppe ist sicherzustellen, dass die ersten und zweiten Primärleiterenden sich in ihrer finalen Position in unmittelbarer Nähe der in die Einbauöffnung eines jeden Gehäusemoduls hineinragenden Anschlusskontakte des jeweiligen Gehäusemoduls befinden, während des Einschiebens der Einschub-Summenstromwandler-Baugruppe jedoch nicht mit diesen Anschlusskontakten kollidieren. Bedingt durch die Modulbauweise des Reiheneinbaugerätes befinden sich die Anschlusskontakte der einzelnen Gehäusemodule alle in einer Ebene. Um ein kollisionsfreies Einschieben in den modulübergreifenden Einbauraum zu ermöglichen weist die Einschub-Summenstromwandler-Baugruppe einen Primärleiterhalter auf, welcher zwischen einer Fixierposition und einer Freigabeposition bewegbar ist, wobei die Primärleiterenden in der Fixierposition des Primärleiterhalters eine Montageposition einnehmen, in der die Einschub-Summenstromwandler-Baugruppe kollisionsfrei in den modulübergreifenden Einbauraum eingeschoben werden kann, wohingegen sie in der Freigabeposition des Primärleiterhalters eine Fügeposition einnehmen, bei der jedes der ersten und zweiten Primärleiterenden in unmittelbarer Nähe des ihm eindeutig zugeordneten Anschlusskontakts positioniert ist, so dass die Primärleiterenden mit dem ihnen jeweils zugeordneten Anschlusskontakt durch ein geeignetes Fügeverfahren auf einfache Art und Weise elektrisch leitend verbunden werden können. Abschließend wird der modulübergreifende Einbauraum zum Schutz vor unbefugter Berührung sowie vor Umgebungseinflüssen wie Staub oder Feuchtigkeit beidseitig verschlossen.

In einer vorteilhaften Weiterbildung der Einschub-Summenstromwandler-Baugruppe sind die die ersten und zweiten Primärleiterenden in der Montageposition radial von dem rohrförmigen Summenstromwandler abstehend ausgebildet.

Mit dem Begriff "radial" ist gemeint, dass die ersten und zweiten Primärleiterenden im Wesentlichen radial, d.h. keinesfalls axial oder im Wesentlichen axial, von dem rohrförmigen Summenstromwandler abstehen. Auf diese Weise können die Einschub-Summenstromwandler-Baugruppe und der Primärleiterhalter während der Einschubbewegung in den modulübergreifenden Einbauraum kompakt gehalten werden, so dass eine Kollision mit den Anschlusskontakten des Reiheneinbaugerätes sicher vermieden werden kann.

In einer weiteren vorteilhaften Weiterbildung weist die Einschub-Summenstromwandler-Baugruppe eine Führungskontur auf, welche beim Einschieben in den modulübergreifenden Einbauraum mit einer dort ausgebildeten Führungskontur zusammenwirkt, um ein kollisionsfreies Einschieben der Einschub-Summenstromwandler-Baugruppe in den modulübergreifenden Einbauraum zu ermöglichen. Auf diese Weise wird die Montage der Einschub-Summenstromwandler-Baugruppe weiter vereinfacht.

In einer weiteren vorteilhaften Weiterbildung der Einschub-Summenstromwandler-Baugruppe sind die ersten und zweiten Primärleiterenden in ihrer Montageposition gegen die Eigenelastizität des ersten und zweiten Primärleiters fixierbar.

Hieraus ergibt sich der Vorteil, dass die ersten und zweiten Primärleiterenden in ihrer Montageposition durch den Primärleiterhalter in dessen Fixierposition lediglich gegen ihre Eigenelastizität fixiert werden müssen. Durch Verbringen des Primärleiterhalters in seine Montageposition sind die ersten und zweiten Primärleiterenden freigegeben, so dass sie sich aufgrund der Eigenelastizität des ersten und zweiten Primärleiters in ihre jeweilige Fügeposition bewegen. Die Montage wird dadurch weiter vereinfacht.

In einer weiteren vorteilhaften Weiterbildung der Einschub-Summenstromwandler-Baugruppe weist der Primärleiterhalter eine Schnappverbindung auf, deren Lösen einen Übergang von der Fixierposition in die Freigabeposition bewirkt.

Mittels der Schnappverbindung werden die ersten und zweiten Primärleiterenden durch den Primärleiterhalter in seiner Fixierposition in ihrer Montageposition fixiert. Durch Lösen der Schnappverbindung wird der Primärleiterhalter in seine Freigabeposition verbracht, in der die ersten und zweiten Primärleiterenden nicht mehr in ihrer jeweiligen Montageposition fixiert werden und sich in ihre jeweilige Fügeposition bewegen können - entweder geführt durch den Primärleiterhalter oder frei aufgrund der Eigenelastizität des ersten und zweiten Primärleiters. Das Lösen der Schnappverbindung kann dabei sowohl manuell als auch automatisiert initiiert sein.

In einer weiteren vorteilhaften Weiterbildung der Einschub-Summenstromwandler-Baugruppe ist zumindest ein weiterer Primärleiter durch den Summenstromwandler hindurchgeführt.

Ist die Einschub-Summenstromwandler-Baugruppe für ein drei- oder vierpoliges, modular gebildetes Reiheneinbaugerät vorgesehen, so ist entsprechend ein dritter und ggf. ein vierter Primärleiter durch den Summenstromwandler hindurchzuführen. Auf diese Weise können mit einer deutlich reduzierten Anzahl an Baugruppen und Komponenten verschiedene Reiheneinbaugeräte unterschiedlicher Polzahl gebildet werden. Durch die Verwendung gleicher Teile und Komponenten werden die Herstellkosten deutlich reduziert.

Das erfindungsgemäße modular gebildete, mehrpolige Reiheneinbaugerät weist zumindest ein erstes und ein zweites Gehäusemodul mit jeweils einer Frontseite, einer der Frontseite gegenüberliegenden Befestigungsseite sowie die Front- und die Befestigungsseite verbindenden ersten und zweiten Schmal- und Breitseiten auf. Jedes Gehäusemodul weist dabei eine von der ersten zur zweiten Breitseite verlaufende Öffnung auf, welche bei Verbinden der zumindest zwei Gehäusemodule zu einem Isolierstoffgehäuse einen modulübergreifenden Einbauraum bilden. wobei in jedem der Gehäusemodule zwei Anschlusskontakte in die jeweilige Öffnung hineinragen. Weiterhin weist das modular gebildete, mehrpolige Reiheneinbaugerät eine Einschub-Summenstromwandler-Baugruppe der vorstehend beschriebenen Art auf, wobei die ersten und zweiten Primärleiterenden in ihrer jeweiligen Fügeposition unmittelbar benachbart zu dem ihnen jeweils zugeordneten Anschlusskontakt angeordnet sind.

Hinsichtlich der grundsätzlichen Vorteile des erfindungsgemä-ßen Reiheneinbaugerätes mit einer Einschub-Summenstromwandler-Baugruppe wird auf die vorstehenden Ausführungen die erfindungsgemäße Einschub-Summenstromwandler-Baugruppe betreffend verwiesen.

Aus dem ersten und dem zweiten Gehäusemodul ist ein zweipoliges modulares Reiheneinbaugerät gebildet, beispielsweise ein Fehlerstrom-Leitungsschutzschalter zum Anschließen an einen Phasenleiter und einen Neutralleiter. Werden ein oder zwei weitere Gehäusemodule hinzugefügt, so ist derart ein drei- oder vierpoliges modulares Reiheneinbaugerät, beispielsweise ein drei- oder vierpoliger Fehlerstrom-Leitungsschutzschalter zum Anschließen an zwei oder drei Phasenleiter sowie einen Neutralleiter, gebildet. Lediglich die Einschub-Summenstromwandler-Baugruppe muss wegen der zusätzlichen Anzahl an Polen entsprechend mit mehreren Primärleitern ausgestattet werden. Das Reiheneinbaugerät ist somit ohne großen Aufwand und ohne einen damit verbundenen, deutlichen Anstieg der Bauteile-Vielfalt, modular erweiterbar, wodurch der Aufwand für Herstellung, Lagerhaltung und Logistik deutlich reduziert werden kann.

In einer vorteilhaften Weiterbildung des modular gebildeten, mehrpoligen Reiheneinbaugerätes sind die Anschlusskontakte gabelförmig ausgebildet.

Die gabelförmigen Anschlusskontakte haben den Vorteil, dass die ersten und zweiten Primärleiterenden beim Verbringen in ihre jeweilige Fügeposition zwischen den Zinken der gabelförmigen Enden der Anschlusskontakte positioniert werden, wodurch der anschließende Fügevorgang, d.h. das Herstellen einer elektrisch leitenden Verbindung zwischen dem jeweiligen Primärleiterende und dem diesem jeweils zugeordneten Anschlusskontakt, deutlich vereinfacht wird.

Das erfindungsgemäße Verfahren zur Montage einer Einschub-Summenstromwandler-Baugruppe der vorstehend beschriebenen Art in einem modulübergreifenden Einbauraum eines modular gebildeten, mehrpoligen Isolierstoffgehäuses eines modular gebildeten, mehrpoligen Reiheneinbaugerätes der vorstehend beschriebenen Art weist die Schritte:
a) Fixieren der ersten und zweiten Primärleiterenden in ihrer jeweiligen Montageposition mit Hilfe des Primärleiterhalters;
b) Einschieben der Einschub-Summenstromwandler-Baugruppe in einer ersten Richtung in den modulübergreifenden Einbauraum;
c) Lösen des Primärleiterhalters, wobei die Primärleiterenden in einer quer zur ersten Richtung verlaufenden zweiten Richtung in ihre jeweilige Fügeposition bewegt werden.
auf. Hinsichtlich der prinzipiellen Vorteile des erfindungsgemäßen Montageverfahrens wird auf die vorstehenden Aussagen die Vorteile der erfindungsgemäßen Einschub-Summenstromwandler-Baugruppe sowie des erfindungsgemäßen modular gebildeten, mehrpoligen Reiheneinbaugerätes verwiesen. Darüber hinaus hat das erfindungsgemäße Montageverfahren den Vorteil, dass durch das Verbringen des Primärleiterhalters von seiner Fixierposition in die Freigabeposition die Primärleiterenden von ihrer jeweiligen Montageposition, die sie bei der in der ersten Richtung erfolgenden Einschieben der Einschub-Summenstromwandler-Baugruppe in den modulübergreifenden Einbauraum in ihre jeweilige Fügeposition einnehmen, durch eine Bewegung in der zweiten Richtung in ihre jeweilige Fügeposition, bei der sie in unmittelbarer Nähe des dem jeweiligen Primärleiterende jeweils zugeordneten Anschlusskontakt positioniert sind, verbracht werden. Der Montagevorgang wird dadurch deutlich vereinfacht und kann sowohl von Hand als auch automatisiert ausgeführt werden.

Im Folgenden wird ein Ausführungsbeispiel der Einschub-Summenstromwandler-Baugruppe zum Einschieben in einen modulübergreifenden Einbauraum eines aus mehreren Gehäusemodulen gebildeten, mehrpoligen Reiheneinbaugerätes, des modular gebildeten, mehrpoligen Reiheneinbaugerätes mit einer derartigen Einschub-Summenstromwandler-Baugruppe sowie des Montageverfahrens der Einschub-Summenstromwandler-Baugruppe in einem derartigen modularen Reiheneinbaugerät unter Bezug auf die beigefügten Figuren näher erläutert. In den Figuren sind:
- Figur 1: schematische Darstellung der erfindungsgemäßen Einschub-Summenstromwandler-Baugruppe in perspektivischer Ansicht;
- Figur 2: schematische Detaildarstellung des Summenstromwandlers mit dem daran befestigten Primärleiterhalter;
- Figuren 3 und 4: schematische Darstellungen des erfindungsgemäßen, aus mehreren Gehäusemodulen gebildeten, mehrpoligen Reiheneinbaugerätes ohne die Einschub-Summenstromwandler-Baugruppe;
- Figur 5: eine schematische Darstellung des erfindungsgemäßen Reiheneinbaugerätes aus den Figuren 3 und 4 beim Einschieben der Einschub-SummenstromwandlerBaugruppe;
- Figuren 6 bis 9: schematische Detaildarstellungen der in das Reiheneinbaugerät eingeschobenen Einschub-Summenstromwandler-Baugruppe in verschiedenen Montagezuständen;
- Figur 10: eine schematische Darstellung des erfindungsgemäßen Montageverfahrens.

In den verschiedenen Figuren der Zeichnung sind gleiche Teile stets mit dem gleichen Bezugszeichen versehen. Die Beschreibung gilt für alle Zeichnungsfiguren, in denen das entsprechende Teil ebenfalls zu erkennen ist.

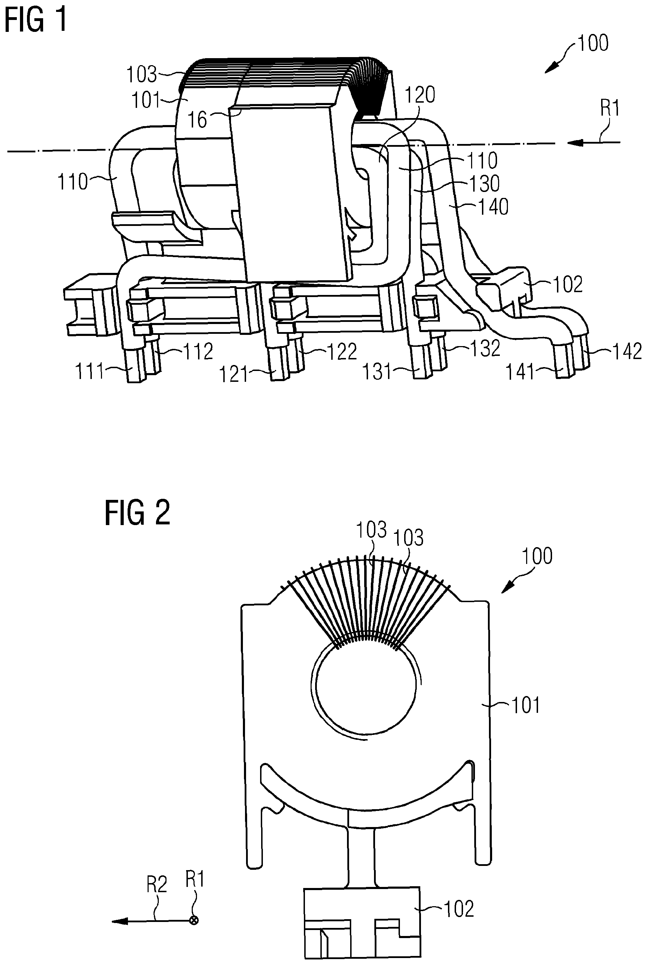

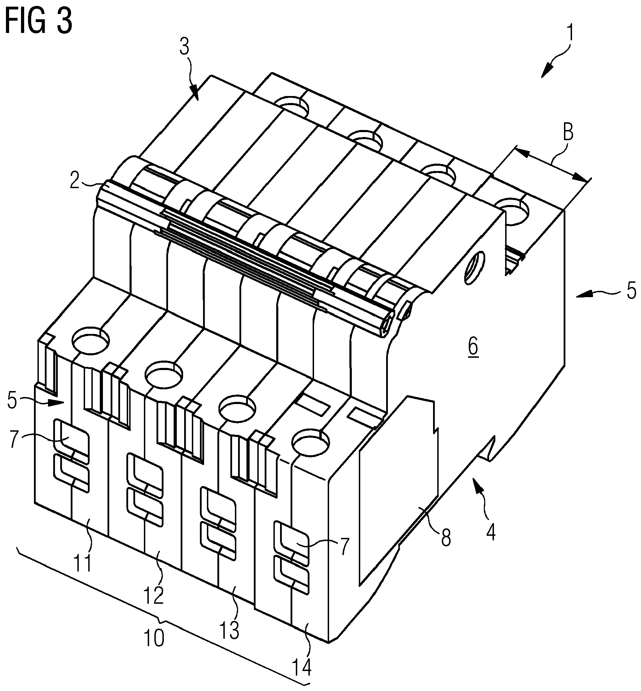

In Figur 1 ist die erfindungsgemäßen Einschub-Summenstromwandler-Baugruppe 100 in perspektivischer Ansicht schematisch dargestellt. Die Einschub-Summenstromwandler-Baugruppe 100 ist zur Montage in einem vierpoligen modularen Reiheneinbaugerät (siehe Figur 3 bis 8) vorgesehen und weist einen rohrförmigen Summenstromwandler 101 auf, welcher aus einem Magnetkern (nicht explizit dargestellt) besteht, der zum Schutz vor Beschädigung in einem rohrförmigen Gehäuse, das sich in einer ersten Richtung R1 erstreckt, aufgenommen ist. Am Gehäuse des Summenstromwandlers 101 ist eine Führungskontur 16 ausgebildet. Der Summenstromwandler 101 weist ferner eine Sekundärwicklung 103 auf, welche zumindest abschnittsweise um das Magnetkerngehäuse gewickelt ist.

Weiterhin weist die Einschub-Summenstromwandler-Baugruppe 100 vier Primärleiter, einen ersten Primärleiter 110 mit einem ersten Primärleiterende 111 und einem zweiten Primärleiterende 112, einen zweiten Primärleiter 120 mit einem ersten Primärleiterende 121 und einem zweiten Primärleiterende 122, einen dritten Primärleiter 130 mit einem ersten Primärleiterende 131 und einem zweiten Primärleiterende 132 sowie einen vierten Primärleiter 140 mit einem ersten Primärleiterende 141 und einem zweiten Primärleiterende 142 auf, welche durch die Öffnung des rohrförmigen Gehäuses des Summenstromwandlers 101 hindurchgeführt sind.

Ferner weist die Einschub-Summenstromwandler-Baugruppe 100 einen Primärleiterhalter 102 auf, welcher mit dem Gehäuse des Summenstromwandlers 101 mechanisch verbunden ist. Der Primärleiterhalter ist zwischen einer Fixierposition und einer Freigabeposition bewegbar und dient dazu, die ersten und zweiten Primärleiterenden 111, 112, 121, 122, 131, 132, 141 und 142 in der Fixierposition so zu fixieren, dass sich eine kompakte Anordnung der ersten und zweiten Primärleiterenden 111, 112, 121, 122, 131, 132, 141 und 142 unterhalb des Summenstromwandlers, die sogenannte Montageposition, ergibt.

Figur 2 zeigt dabei eine Detaildarstellung des Summenstromwandlers 101 mit dem daran befestigten Primärleiterhalter 102 in einer Frontalansicht mit Blick in Richtung der ersten Richtung R1. Bei dieser Darstellung ist u.a. die Befestigung des Primärleiterhalters 102 am Gehäuse des Summenstromwandlers 101 gut zu erkennen, welche im dargestellten Fall formschlüssig mittels einer Steckverbindung realisiert ist. Dies ist jedoch nicht erfindungswesentlich, andere Verbindungsarten bis hin zum einstückigen Anformen des Primärleiterhalters 102 an das Gehäuse des Summenstromwandlers 101 sind hier ebenso vorstellbar.

Sowohl Figur 2 als auch Figur 1 zeigen den Primärleiterhalter 102 jeweils in seiner Fixierposition, bei der die Primärleiterenden 111, 112, 121, 122, 131, 132, 141 und 142 kompakt unterhalb des Summenstromwandlers 101 gehalten und fixiert sind, so dass sie in einer quer zur ersten Richtung R1 orientierten zweiten Richtung R2 möglichst kompakt gehalten sind, d.h. möglichst wenig Platz einnehmen.

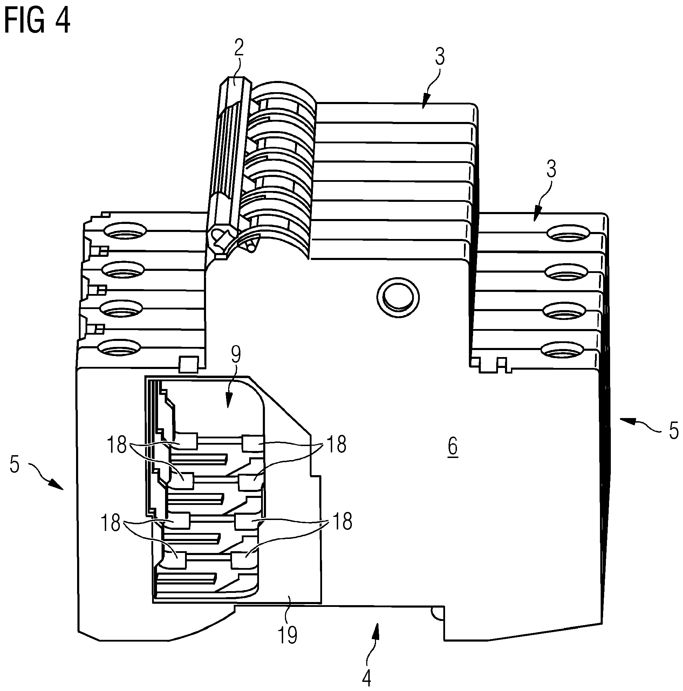

Die Figuren 3 und 4 zeigen schematisch das erfindungsgemäße, aus mehreren Gehäusemodulen gebildete, mehrpolige Reiheneinbaugerät 1 ohne die Einschub-Summenstromwandler-Baugruppe 100. Das in den Figuren 3 und 4 dargestellte mehrpolige Reiheneinbaugerät 1 ist als vierpoliger FI/LS bzw. RCBO ausgebildet und weist ein Isolierstoffgehäuse 10 auf, welches aus einem ersten Gehäusemodul 11, einem zweiten Gehäusemodul 12, einem dritten Gehäusemodul 13 und einem vierten Gehäusemodul 14 gebildet ist. Dabei ist das vierte Gehäusemodul 14 als RCD-Modul (in Figur 3 rechts dargestellt) ausgebildet, d.h. es ist mit den für einen Fehlerstromschutzschalter typischen Komponenten bestückt und zur Kontaktierung des Neutralleiters vorgesehen, während die ersten drei Gehäusemodule 11, 12, und 13 als MCB-Module ausgebildet und dementsprechend mit den für einen Leitungsschutzschalter typischen Komponenten bestückt sind. Die drei MCB-Module 11, 12, und 13 sind dementsprechend jeweils zur Kontaktierung mit jeweils einem diesem Modul eindeutig zugeordneten Phasenleiter eines dreiphasigen Energieverteilsystems vorgesehen.

Jedes der vier Gehäusemodule 11, 12, 13 und 14 ist in Schmalbauweise ausgeführt und weist eine Breite B von einer Teilungseinheit (1TE, entspr. ca. 18mm) auf, wobei die die Au-ßenmaße definierenden Hüllflächen durch eine Frontseite 3, eine dieser gegenüberliegend angeordnete Befestigungsseite 4 sowie die Front- und die Befestigungsseite 3, 4 verbindende Schmalseiten 5 und Breitseiten 6 gebildet sind. Im Bereich der Schmalseiten 5 sind jeweils Schraubklemmen 7 zur Kontaktierung mit netz- bzw. lastseitigen Anschlussleitern - Phasenleiter bzw. Neutralleiter (nicht dargestellt) - im jeweiligen Gehäusemodul 11, 12, 13, 14 aufgenommen und gehaltert. Zur manuellen Betätigung weist jedes der Gehäusemodule 11, 12, 13, 14 ein im Bereich seiner Frontseite 11 angeordnetes Betätigungselement auf, wobei die einzelnen Betätigungselemente zur gemeinsamen Betätigung mit Hilfe eines die einzelnen Betätigungselemente verbindenden Griffelements 2 verbunden sind.

In der Regel weisen Isolierstoffgehäuse in Schmalbauweise zwei Halbschalen auf, welche am Ende der Montage des Niederspannungs-Schutzschaltgerätes 1 mittels geeigneter Verbindungsmittel, beispielsweise Niet- oder Rastverbindungen, unter Ausbildung einer umlaufenden Fügelinie zusammengefügt werden. Zu jeder Halbschale gehört dabei eine der Breitseiten 6 sowie Teile (ganz oder vollständig) der Front-, Befestigungs- und Schmalseiten 3, 4, 5. Auch die Gehäusemodule 11, 12, 13, und 14 sind in Schmalbauweise ausgeführt, welche bei der Montage zunächst vollständig bestückt und einzeln verschlossen werden, bevor die einzelnen Gehäusemodule 11, 12, 13 und 14 zu dem strukturmechanisch stabilen Isolierstoffgehäuse 10 des modular gebildeten, mehrpoligen Reiheneinbaugerätes 1 verbunden werden.

In den Breitseiten 6 jedes der Gehäusemodule 11, 12, 13, 14 ist eine Öffnung 19 ausgebildet, welche sich orthogonal zu den Breitseiten 6 von der einen zur anderen Breitseite 6 des jeweiligen Gehäusemoduls 11, 12, 13, 14 erstreckt. In die jeweilige Öffnung des jeweiligen Gehäusemoduls 11, 12, 13, 14 ragen seitlich zwei elektrische Anschlusskontakte 18 des jeweiligen Gehäusemoduls 11, 12, 13, 14 hinein, um mit einem dem jeweiligen Anschlusskontakt 18 eindeutig zugeordneten ersten bzw. zweiten Ende 111, 112, 121, 122, 131, 132, 141, 142 des jeweils eindeutig zugeordneten Primärleiters 110, 120, 130, 140 elektrisch leitend verbunden zu werden. Durch Verbinden der Gehäusemodule 11, 12, 13, 14 zu dem strukturmechanisch stabilen Isolierstoffgehäuse 10 eines modular gebildeten, mehrpoligen Reiheneinbaugerätes 1 entsteht aus den mehreren Öffnungen 19 der einzelnen Gehäusemoduls 11, 12, 13, 14 ein modulübergreifenden Einbauraum 9, in dem die großvolumige Einschub-Summenstromwandler-Baugruppe 100, angeordnet, d.h. aufgenommen und gehaltert wird. Der modulübergreifende Einbauraum 9 ist dabei über jede der beiden Breitseiten 6 des derart gebildeten Isolierstoffgehäuses 10 zugänglich und zum Schutz vor Umwelteinflüssen wie Staub oder Feuchtigkeit mittels geeigneter Verschlusselemente, beispielsweise mit Hilfe eines Deckels 8, verschließbar.

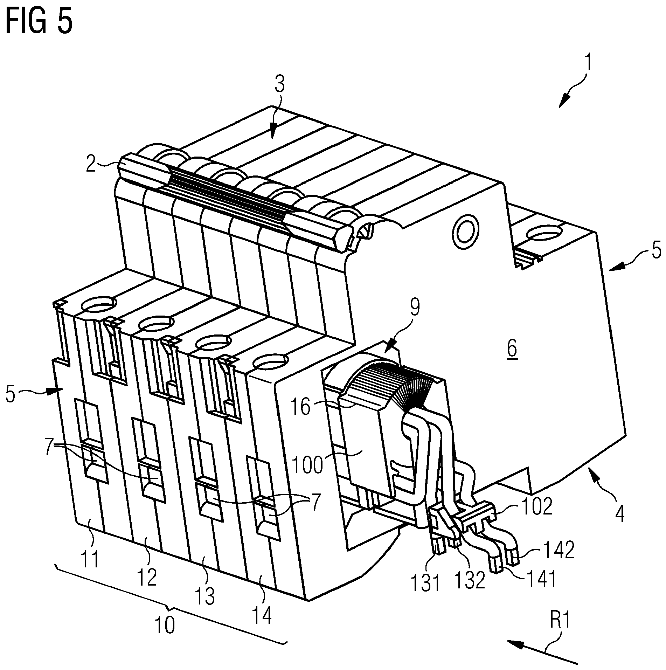

Figur 5 zeigt eine schematische Darstellung des erfindungsgemäßen, aus den Figuren 3 und 4 bekannten, modularen Reiheneinbaugerätes 1 beim Einschieben der Einschub-Summenstromwandler-Baugruppe 100 in der ersten Richtung R1 in den modulübergreifenden Einbauraum 9. Der modulübergreifende Einbauraum 9 wird dabei wie oben beschrieben durch die in den einzelnen Gehäusemodulen 11, 12, 13 und 14 ausgebildeten Öffnungen 19 gebildet. Damit die ersten und zweiten Enden 111, 112, 121, 122, 131, 132, 141, 142 beim Einschieben der Einschub-Summenstromwandler-Baugruppe 100 in der ersten Richtung R1 nicht mit den in den modulübergreifenden Einbauraum 9 hineinragenden Anschlusskontakten 18 kollidieren, werden sie während des Einschiebens in der ersten Richtung R1 durch den Primärleiterhalter 102 in einer kompakten Position unterhalb des Summenstromwandlers 101 fixiert. Der Abstand der ersten und zweiten Enden 111, 112, 121, 122, 131, 132, 141, 142 eines jeden Primärleiters 110, 120, 130, 140 ist dabei etwas kleiner bemessen als der Abstand der beiden innerhalb eines Gehäusemoduls 11, 12, 13, 14 einander gegenüberliegend angeordneter Anschlusskontakte 18.

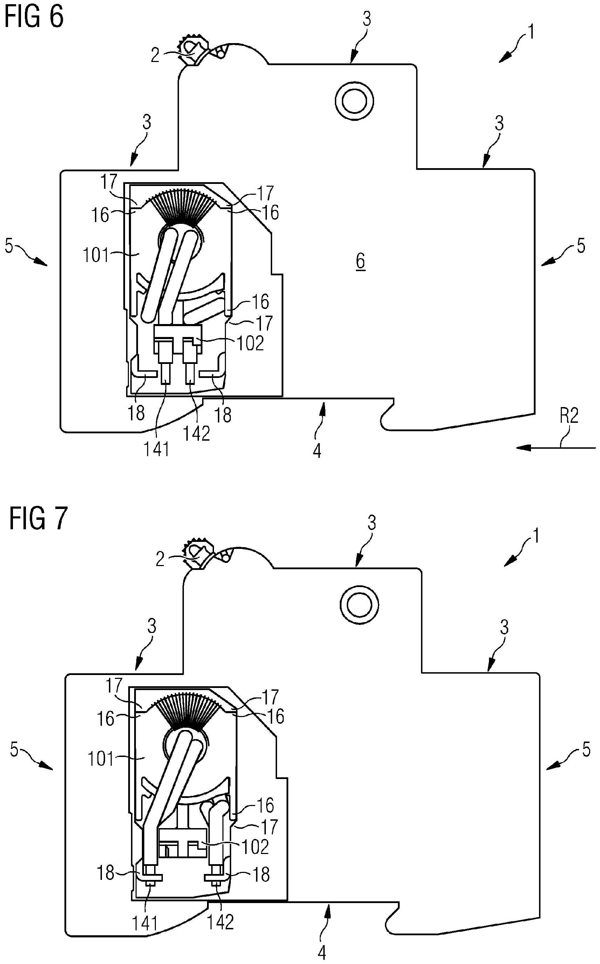

Die Figuren 6 bis 9 zeigen schematische Detaildarstellungen der in das aus mehreren Gehäusemodulen 11, 12, 13, 14 gebildeten, modularen, mehrpoligen Reiheneinbaugerät 1 eingeschobenen Einschub-Summenstromwandler-Baugruppe 100. Figuren 6 und 7 zeigen dabei eine Seitenansicht auf die vordere Breitseite 6, nachdem die Einschub-Summenstromwandler-Baugruppe 100 vollständig in das Isolierstoffgehäuse 10 des modularen, mehrpoligen Reiheneinbaugerätes 1 eingeschoben worden ist. Figur 6 zeigt dabei einen ersten Montagezustand, bei dem sich der Primärleiterhalter 102 noch in seiner Fixierposition befindet, so dass die ersten und zweiten Enden 111, 112, 121, 122, 131, 132, 141, 142 der Primärleiter 110, 120, 130, 140 noch die für das Einschieben in den modulübergreifenden Einbauraum 9 erforderliche kompakte Position, die Montageposition, mittig unterhalb des Summenstromwandlers 101 einnehmen.

In Figur 7 ist ein zweiter Montagezustand dargestellt, bei dem der Primärleiterhalter 102 in seine Freigabeposition verbracht wurde. Dieser Übergang von der Fixierposition in die Freigabeposition kann bei einem mehrteiligen Primärleiterhalter 102 beispielsweise durch eine Verschiebebewegung der beiden Teile des Primärleiterhalters 102 relativ zueinander erfolgen, durch die die ersten und zweiten Enden 111, 112, 121, 122, 131, 132, 141, 142 von ihrer Montageposition mittig unterhalb des Summenstromwandlers 101 in ihre Fügeposition gedrängt werden. Alternativ dazu kann der Übergang von der Fixierposition in die Freigabeposition auch durch eine oder mehrere Schnappverbindungen am Primärleiterhalter 102 realisiert werden. Dabei wäre auch eine einteilige Gestaltung des Primärleiterhalters 102 möglich. Ebenso können die ersten und zweiten Enden 111, 112, 121, 122, 131, 132, 141, 142 entweder durch den Primärleiterhalter 102 von ihrer Montageposition in die Fügeposition gedrängt werden, oder die ersten und zweiten Enden 111, 112, 121, 122, 131, 132, 141, 142 waren in der Fixierposition auf Spannung gehaltert und werden beim Übergang in die Freigabeposition lediglich freigegeben, so dass sie sich aufgrund ihrer Eigenelastizität in ihre jeweilige Fügeposition bewegen.

In der Fügeposition befindet sich dann jedes der ersten und zweiten Primärleiterenden 111, 112, 121, 122, 131, 132, 141, 142 in unmittelbarer Nähe des ihm eindeutig zugeordneten Anschlusskontakts 18, so dass die Primärleiterenden 111, 112, 121, 122, 131, 132, 141, 142 mit dem ihnen jeweils zugeordneten Anschlusskontakt 18 durch ein geeignetes Fügeverfahren auf einfache Art und Weise elektrisch leitend verbunden werden können. Weiterhin sind in den Figuren 6 und 7 die an der Einschub-Summenstromwandler-Baugruppe 100 ausgebildeten Führungskonturen 16 welche zum passgenauen Einschieben in den modulübergreifenden Einbauraum 9 mit dort ausgebildeten Führungskonturen 17 zusammenwirken, gut zu erkennen.

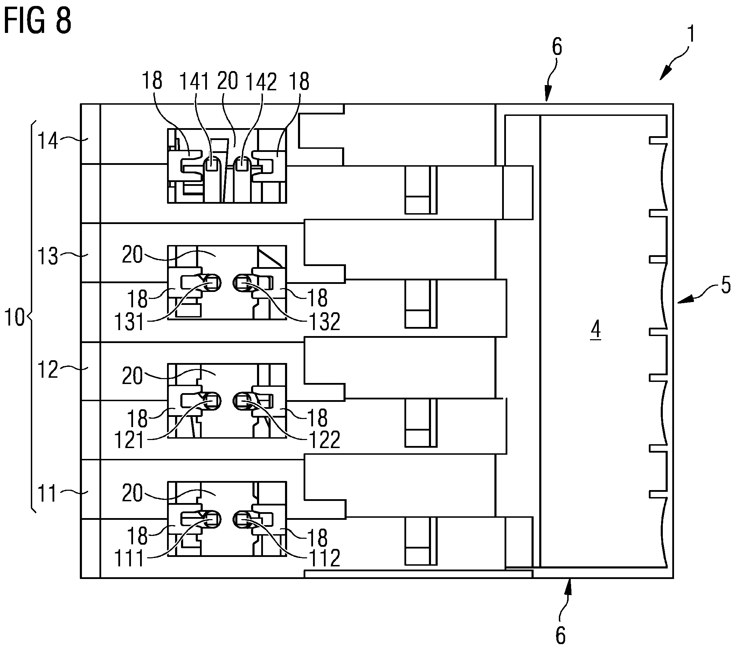

In Figur 8 ist eine Ansicht auf die Befestigungsseite 6 des aus mehreren Gehäusemodulen 11, 12, 13, 14 gebildeten, modularen, mehrpoligen Reiheneinbaugerätes 1 mit der in den modulübergreifenden Einbauraum 9 eingeschobenen Einschub-Summenstromwandler-Baugruppe 100 schematisch dargestellt. Jedes der Gehäusemodule 11, 12, 13, 14 weist eine in der Befestigungsseite 4 ausgebildete weitere Öffnung 20 auf, welche unterhalb der dem jeweiligen Gehäusemodul 11, 12, 13, 14 zugeordneten Öffnung 19 angeordnet ist und bis in diese hineinreicht. Die weiteren Öffnungen 20 sind mit einzelnen oder einem gemeinsamen Deckel (nicht dargestellt) verschließbar. Da sich der Primärleiterhalter 102 noch in seiner Fixierposition befindet, befinden sich die ersten und zweiten Enden 111, 112, 121, 122, 131, 132, 141, 142 der Primärleiter 110, 120, 130, und 140 noch in ihrer jeweiligen Montageposition. Durch Bewegen des Primärleiterhalters 102 in seine Freigabeposition werden die ersten und zweiten Enden 111, 112, 121, 122, 131, 132, 141, 142 in ihre jeweilige Fügeposition verbracht, um mit dem ihnen jeweils eindeutig zugeordneten Anschlusskontakt 18 elektrisch leitend verbunden zu werden.

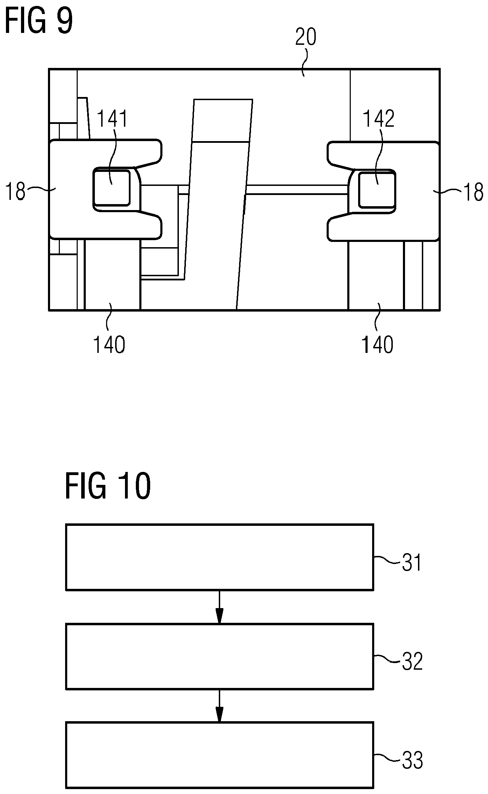

Figur 9 zeigt hierzu eine Detaildarstellung, bei der sich die beiden Enden 141, 142 des vierten Primärleiters 140 in ihrer jeweiligen Fügeposition befinden. Die Anschlusskontakte 18 sind gabelförmig ausgebildet, wodurch das Fügen deutlich erleichtert wird. Das zur Herstellung der elektrisch leitenden Verbindung eingesetzte Fügeverfahren, beispielsweise Löten, Schweißen oder Crimpen, kann dabei auf einfache Art und Weise durch die in der Befestigungsseite 4 ausgebildeten Öffnungen 20 ausgeführt werden.

In Figur 10 ist das erfindungsgemäße Verfahren zur Montage der erfindungsgemäßen Einschub-Summenstromwandler-Baugruppe 100 im modulübergreifenden Einbauraum 9 des modular gebildeten, mehrpoligen Isolierstoffgehäuses 10 des erfindungsgemä-ßen, modular gebildeten, mehrpoligen Reiheneinbaugerätes 1 schematisch dargestellt.

Dabei werden in einem ersten Schritt 31 die ersten und zweiten Enden 111, 112, 121, 122, 131, 132, 141, 142 der Primärleiter 110, 120, 130, 140 in ihrer jeweiligen Montageposition mit Hilfe des Primärleiterhalters 102 fixiert. Dieser Schritt stellt somit die Vormontage der Einschub-Summenstromwandler-Baugruppe 100 dar.

In einem zweiten Schritt 32 wird die Einschub-Summenstromwandler-Baugruppe 100 in der ersten Richtung R1 in den modulübergreifenden Einbauraum 9 des modular gebildeten, mehrpoligen Reiheneinbaugerätes 1 eingeschoben. Dabei sind die ersten und zweiten Enden 111, 112, 121, 122, 131, 132, 141, 142 kompakt unterhalb des Summenstromwandlers 101 gehalten, wodurch eine Kollision mit den in den modulübergreifenden Einbauraum 9 hineinragenden Anschlusskontakten 18 vermieden wird.

In einem dritten Schritt 33 wird die Fixierung der ersten und zweiten Enden 111, 112, 121, 122, 131, 132, 141, 142 durch den Primärleiterhalter 102 gelöst, indem dieser von seiner Fixierposition in seine Freigabeposition verbracht wird, wodurch die ersten und zweiten Enden 111, 112, 121, 122, 131, 132, 141, 142 in einer quer zur ersten Richtung R1 verlaufenden zweiten Richtung R2 von ihrer jeweiligen Montageposition in ihre jeweilige Fügeposition bewegt werden.

Mit Hilfe des erfindungsgemäßen Montageverfahrens wird der Montagevorgang deutlich vereinfacht, wobei die Montage sowohl von Hand als auch (teil-)automatisiert ausgeführt werden kann.

### Bezugszeichenliste

- 1: Reiheneinbaugerät
- 2: Griffelement
- 3: Frontseite
- 4: Befestigungsseite
- 5: Schmalseite
- 6: Breitseite
- 7: Schraubklemme
- 8: Deckel
- 9: modulübergreifender Einbauraum
- 10: Isolierstoffgehäuse
- 11: erstes Gehäusemodul
- 12: zweites Gehäusemodul
- 13: drittes Gehäusemodul
- 14: viertes Gehäusemodul
- 16: Führungskontur
- 17: Führungskontur
- 18: Anschlusskontakt
- 19: Öffnung
- 20: weitere Öffnung

- 31: erster Schritt
- 32: zweiter Schritt
- 33: dritter Schritt

- 100: Einschub-Summenstromwandler-Baugruppe
- 101: Summenstromwandler
- 102: Primärleiterhalter
- 103: Sekundärwicklung

- 110: erster Primärleiter
- 111: erstes Primärleiterende
- 112: zweites Primärleiterende
- 120: zweiter Primärleiter
- 121: erstes Primärleiterende
- 122: zweites Primärleiterende
- 130: erster Primärleiter
- 131: erstes Primärleiterende
- 132: zweites Primärleiterende
- 140: erster Primärleiter
- 141: erstes Primärleiterende
- 142: zweites Primärleiterende

- B: Breite
- R1: erste Richtung
- R2: zweite Richtung

## Patentansprüche

1. Einschub-Summenstromwandler-Baugruppe (100) zum Einschieben in einen modulübergreifenden Einbauraum (9) eines aus mehreren Gehäusemodulen (11, 12, 13, 14) gebildeten, mehrpoligen Reiheneinbaugerätes (1), aufweisend:
- einen Summenstromwandler (101),
- zumindest einem ersten (110) und einem zweiten (120) Primärleiter, welche jeweils zumindest einmal durch den rohrförmigen Summenstromwandler hindurchgeführt sind und jeweils ein erstes (111, 121) und ein zweites (112, 122) Primärleiterende aufweisen,
- einen am Summenstromwandler (101) befestigten Primärleiterhalter (102) zum Fixieren der ersten und zweiten Primärleiterenden (111, 112, 121, 122), wobei der Primärleiterhalter (102) zwischen einer Fixierposition und einer Freigabeposition bewegbar und dazu ausgebildet ist,
- in der Fixierposition die ersten und zweiten Primärleiterenden (111, 112, 121, 122) während des Einschiebens in den modulübergreifenden Einbauraum (9) in einer jeweiligen Montageposition zu halten und
- nach dem Einschieben durch Bewegen in die Freigabeposition die ersten und zweiten Primärleiterenden (111, 112, 121, 122) in eine jeweilige Fügeposition zu verbringen.

2. Einschub-Summenstromwandler-Baugruppe (100) nach Anspruch 1, wobei die ersten und zweiten Primärleiterenden (111, 112, 121, 122) in der Montageposition radial von dem rohrförmigen Summenstromwandler (101) abstehen.

3. Einschub-Summenstromwandler-Baugruppe (100) nach einem der vorherigen Ansprüche, aufweisend eine Führungskontur (16), welche beim Einschieben in den modulübergreifenden Einbauraum (9) mit einer dort ausgebildeten Führungskontur (17) zusammenwirkt, um ein kollisionsfreies Einschieben zu ermöglichen.

4. Einschub-Summenstromwandler-Baugruppe (100) nach einem der vorherigen Ansprüche, wobei die ersten und zweiten Primärleiterenden (111, 112, 121, 122) in ihrer Montageposition gegen die Eigenelastizität des ersten (110) und zweiten Primärleiters (120) fixierbar sind.

5. Einschub-Summenstromwandler-Baugruppe (100) nach einem der vorherigen Ansprüche, wobei der Primärleiterhalter (102) eine Schnappverbindung aufweist, deren Lösen einen Übergang von der Fixierposition in die Freigabeposition bewirkt.

6. Einschub-Summenstromwandler-Baugruppe (100) nach einem der vorherigen Ansprüche, wobei zumindest ein weiterer Primärleiter (130, 140) durch den Summenstromwandler (101) hindurchgeführt ist.

7. Modular gebildetes, mehrpoliges Reiheneinbaugerät (1),
- mit zumindest einem ersten und einem zweiten Gehäusemodul (11, 12, 13, 14), aufweisend eine Frontseite (3), einer der Frontseite (3) gegenüberliegende Befestigungsseite (4) sowie die Front- und die Befestigungsseite (3, 4) verbindende ersten und zweiten Schmal- (5) und Breitseiten (6), wobei jedes Gehäusemodul (11, 12, 13, 14) eine von der ersten zur zweiten Breitseite (6) verlaufende Öffnung (19) aufweist, welche bei Verbinden der zumindest zwei Gehäusemodule (11, 12, 13, 14) zu einem Isolierstoffgehäuse (10) einen modulübergreifenden Einbauraum (9) bilden, wobei in jedem der Gehäusemodule (11, 12, 13, 14) zwei Anschlusskontakte (18) in die jeweilige Öffnung (19) hineinragen,
- mit einer nach einem der Ansprüche 1 bis 6 gebildeten Einschub-Summenstromwandler-Baugruppe (100), wobei die ersten und zweiten Primärleiterenden (111, 112, 121, 122, 131, 132, 141, 142) in ihrer jeweiligen Fügeposition unmittelbar benachbart zu dem ihnen jeweils zugeordneten Anschlusskontakt (18) angeordnet sind.

8. Modular gebildetes, mehrpoliges Reiheneinbaugerät (1) nach Anspruch 7, wobei die Anschlusskontakte (18) gabelförmig ausgebildet sind.

9. Verfahren zur Montage einer nach einem der Ansprüche 1 bis 6 gebildeten Einschub-Summenstromwandler-Baugruppe (100) in einem modulübergreifenden Einbauraum (9) eines modular gebildeten, mehrpoligen Isolierstoffgehäuses (10) eines modular gebildeten, mehrpoligen Reiheneinbaugerätes (1) nach einem der Ansprüche 7 oder 8, mit den Schritten:
a) Fixieren der ersten und zweiten Primärleiterenden (111, 112, 121, 122, 131, 132, 141, 142) in ihrer jeweiligen Montageposition mit Hilfe des Primärleiterhalters (102);
b) Einschieben der Einschub-Summenstromwandler-Baugruppe (100) in einer ersten Richtung (R1) in den modulübergreifenden Einbauraum (9);
c) Lösen des Primärleiterhalters (102), wobei die Primärleiterenden (111, 112, 121, 122, 131, 132, 141, 142) in einer quer zur ersten Richtung (R1) verlaufenden zweiten Richtung (R2) in ihre jeweilige Fügeposition bewegt werden.
